# EUROPÄISCHE PATENTSCHRIFT

(11) **EP 0 477 393 B1**
(45) Veröffentlichungstag und Bekanntmachung des Hinweises auf die Patenterteilung: **28.12.1994**
(21) Anmeldenummer: 90118326.9
(22) Anmeldetag: 24.09.1990
(51) Int. Cl.: H01L 27/02

(54) **Eingangsschutzstruktur für integrierte Schaltungen**
Input protection structure for integrated circuits
Structure de protection d'entrée pour circuits intégrés

(43) Veröffentlichungstag der Anmeldung: 01.04.1992
(73) Patentinhaber: SIEMENS AKTIENGESELLSCHAFT, 80333 München (DE)
(72) Erfinder: Becker, Burkhard, Dr.rer.nat., D-8000 München 80 (DE)

(56) Entgegenhaltungen:
- GB-A- 2 176 053
- GB-A- 2 182 491
- US-A- 4 870 530
- PATENT ABSTRACTS OF JAPAN vol. 7, no. 103 (E-173)(1248) 6. Mai 1983 ; & JP-A-58 23 471

## Beschreibung

Die Erfindung betrifft eine Eingangsschutzstruktur für integrierte Schaltungen.

Integrierte Schaltungen benötigen einen sicheren Schutz gegen elektrische Entladungen (ESD). Zu diesem Zweck werden die integrierten Schaltungen mit einer Eingangsschutzstruktur versehen. Eine solche Eingangsschutzstruktur, insbesondere für bipolare integrierte Schaltungen, ist aus der DE-A-36 16 394 bekannt.

Um einen wirksamen Schutz gegen elektrostatische Entladungen beider Polaritäten zu erzielen, ist in der europäischen Patentanmeldung EP-A-0 414 934 bereits eine Eingangsschutzstruktur vorgeschlagen, welche zwischen einen Eingang und ein Referenzpotential geschaltet ist. Die Schutzstruktur, die dem Oberbegriff des Patentanspruchs 1 entspricht, ist in einem Halbleitersubstrat angeordnet und enthält mindestens einen Thyristor, der aus einem Gebiet eines ersten Leitungstyps, einem Gebiet eines zweiten Leitungstyps, einer dritten Zone des ersten Leitungstyps und einer vierten Zone des zweiten Leitungstyps gebildet ist. Diese Eingangsschutzstruktur ist durch einen integrierten Widerstand gekennzeichnet, über den die dritte Zone an den Eingang und die vierte Zone gekoppelt ist. Während bei dieser Struktur negative Impulse über die Thyristor-Strecke abgeleitet werden, steht deren Sperrverhalten der Ableitung der positiven Impulse entgegen, so daß diese über die Substrat-pnp-Strecke z.B. nach Masse als Bezugspotential abgeleitet werden. Die Effektivität dieses Pfades ist der der Thyristor-Strecke allerdings unterlegen.

Der Erfindung liegt die Aufgabe zugrunde, eine Eingangsschutzstruktur der vorgeschlagenen Art so zu verbessern bzw. weiterzubilden, daß eine noch höhere ESD-Belastbarkeit bzw. ein effektiverer ESD-Schutz für integrierte Schaltungen erreicht wird.

Diese Aufgabe wird erfindungsgemäß durch eine Eingangsschutzstruktur mit den Merkmalen des Patentanspruchs 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß vor allem eine Verbesserung der Ableitung von positiven Impulsen erreicht wird. Die Wirksamkeit der Schutzstruktur zum Ableiten positiver Impulse wird dadurch verbessert, daß zusätzlich zu den dem Thyristor zugehörigen Diffusionsgebieten zwei p-Gebiete in dasselbe Epitaxie-Gebiet eingebracht und mit dem Thyristoreingang bzw. dem diesen zugeordneten Pad kurzgeschlossen werden. Die p-Gebiete bestehen in der einfachsten Form aus zwei Basis-Diffusionsgebieten. Ein noch wirksamerer ESD-Schutz wird durch zwei Isolations-Diffusions-Gebiete erreicht. Das Einbringen von zwei p-Gebieten statt nur eines erfolgt vor allem aus Symmetriegründen. Dieses zusätzliche p-Gebiet bildet zusammen mit der Buried-Layer eine Diode bzw. mit der Buried-Layer und dem Substrat (bzw. dem Isolationsrahmen) einen Substrat-pnp-Transistor. Gemäß einer Weiterbildung der Erfindung wird der Abstand zwischen den zusätzlichen p-Gebieten und dem Isolationsrahmen der pnp-Basisweite angepaßt. Die Funktion dieser Bauelemente besteht hauptsächlich in dem Einschleusen von freien Ladungsträgern in die bei positiven Impulsen gesperrte Zone zwischen Buried-Layer und Substrat, womit ein frühzeitiger Durchbruch des Thyristors (in Sperrrichtung) angeregt wird. Daneben erhöhen die zusätzlichen p-Gebiete die Emitter-Fläche der Substrat-pnp-Transistoren. Beide Effekte sorgen für eine höhere ESD-Belastbarkeit bzw. für einen effektiveren ESD-Schutz anderer Bauelemente der integrierten Schaltung, und zwar in der Größenordnung von zusätzlich mindestens 1000Volt.

Anhand von in den Figuren der Zeichnung schematisch dargestellten Ausführungsbeispielen wird die Erfindung im folgenden näher erläutert. Es zeigen
- FIG 1: ein Ersatzschaltbild der für die Schutzeinrichtung verwendeten Vier-Schicht-Struktur,
- FIG 2: eine Ausfünrungsform der Eingangsschutzstruktur,
- FIG 3 und 4: Ersatzscnaltbilder der Eingangsschutzstruktur nach FIG 2 und
- FIG 5 und 6: weitere Ausführungsformen einer Eingangsschutzstruktur.

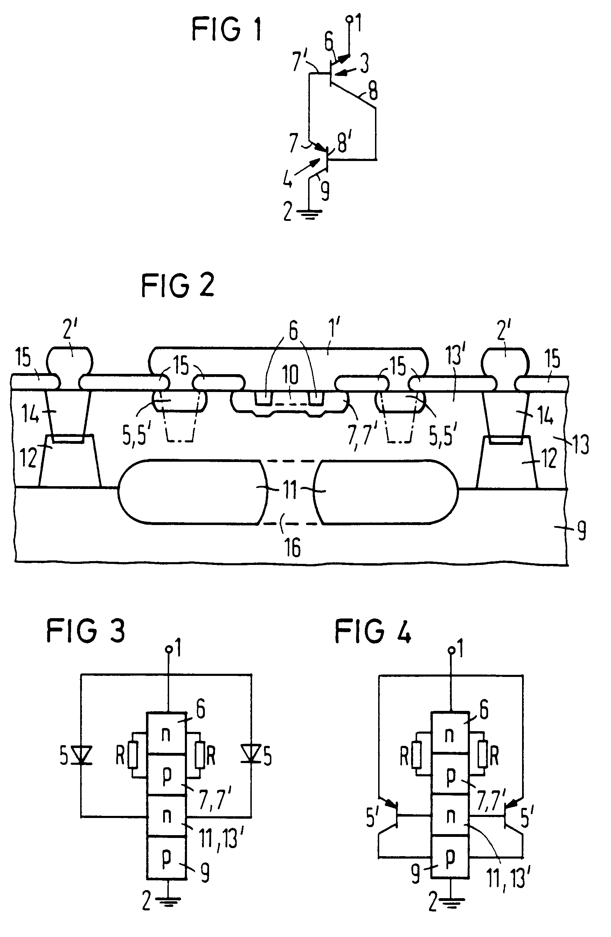

Gemäß FIG 1 liegt zwischen einem Eingangsanschluß 1 einer integrierten Schaltung, insbesondere bipolaren Schaltung, und einem Bezugspotential 2, insbesondere Masse, eine Schutzstruktur in Form einer Thyristor bzw. Vierschicht-Struktur. Diese Struktur wird durch einen ersten Transistor 3 und einen zweiten Transistor 4 charakterisiert, die zu einem Thyristor gekoppelt sind. Bei dem ersten Transistor 3 handelt es sich vorzugsweise um einen npn-Transistor, dessen Emitter 6 mit dem Eingang 1 verbunden ist. Der zweite Transistor 4, vorzugsweise ein pnp-Transistor, ist mit seinem Kollektor 9 an das Bezugspotential 2 angeschlossen. Seine Basis 8′ ist mit dem Kollektor 8 des ersten Transistors 3 und sein Emitter 7 mit der Basis 7′ des ersten Transistors 3 verbunden.

Die in FIG 2 dargestellte und anhand der Ersatzschaltbilder der FIG 3 und 4 erläuterte Eingangsschutzstruktur besteht im wesentlichen aus einem Halbleitersubstrat 9 eines Leitungstyps. In dieses Halbleitersubstrat ist eine hochdotierte erste Zone des zweiten bzw. entgegengesetzten Leitungstyps, in diesem Beispiel also des n-Leitungstyps eindiffundiert, durch die eine vergrabene Schicht bzw. Buried-Layer-Zone 11 gebildet wird. Diese erste Zone 11 weist vorzugsweise eine innere Aussparung 16 auf und besitzt ringförmige Gestalt. Außerdem sind in das Halbleitersubstrat 9 Zonen mit dem Leitungstyp des Substrats eindiffundiert, die Teilzonen eines an sich üblichen Isolationsranmens 12 bilden. In weiteren Diffusionsschritten sind Zonen 14 und eine dritte Zone 7, 7′ in die epitaktische Schicht 13 eingebracht, die beide den Leitungstyp des Halbleitersubstrats 9, d.h. den p-Leitungstyp haben. Dabei vervollständigen die in die Teilzonen 12 hineinreichenden Zonen 14 den die zweite und dritte Zone einschließenden Isolationsrahmen 12, 14. Die dritte Zone 7, 7′ liegt innerhalb der zweiten Zone 13′ und vorzugsweise über der Aussparung 16 der ersten Zone 11. Sie bildet die Basis 7′ des ersten Transistors 3 (FIG 1) und gleichzeitig den Emitter 7 des zweiten Transistors 4 (FIG 1). In die dritte Zone 7, 7′ wird eine vierte Zone 6 mit dem Leitungstyp der zweiten Zone, in diesem Beispiel mit dem n-Leitungstyp, eindiffundiert. Die vierte Zone 6 ist von der zweiten Zone 13′ durch die dritte Zone 7, 7′ isoliert und besitzt in diesem Beispiel eine Aussparung 10, die vorzugsweise über der Aussparung 16 der ersten Zone 11 angeordnet ist. Durch die spezielle Anordnung von dritter und vierter Zone sowie der auf der Oberfläche des Halbleitersystems liegenden isolierenden Schicht 15 wird ein integrierter Widerstand gebildet.

In die zweite Zone 13′ des zweiten Leitungstyps, in diesem bevorzugten Ausführungsbeispiel des n-Leitungstyps, ist zu beiden Seiten der dritten Zone 7, 7′ des ersten, hier p-Leitungstyps, von dieser beabstandet, eine zusätzliche Zone 5, 5′ des ersten, hier also des p-Leitungstyps eindiffundiert und mit dem Eingang 1 kurzgeschlossen. Die zusätzlichen p-Gebiete 5, 5′ können sowohl aus p-Basis-Diffusionsgebieten als auch aus Isolations-Diffusions-Gebieten bestehen. Im zweiten Fall ist eine höhere Schutzwirkung zu erreichen. Diese Alternative ist in den Figuren durch strichpunktierte Linien veranschaulicht.

Auf der Oberfläche des Halbleitersystems ist eine isolierende Schicht 15 aufgebracht, die zur Herstellung von Anschlußöffnungen strukturiert wird. Über einen ersten Anschluß 1′ sind die vierte Zone 6, die dritte Zone 7, 7′ und die zusätzlichen Zonen 5, 5′ an den Eingang 1 angeschlossen. Über einen zweiten Anschluß 2′ ist das Halbleitersubstrat 9 über den Isolationsrahmen 12, 14 an das Bezugspotential 2 angeschlossen.

In den Figuren 3 und 4 ist die vorstehend erläuterte Zonenfolge als Ersatzschaltbild wiedergegeben. Insgesamt stellt die Zonenfolge einen npnp-Thyristor dar, der sich, wie im Zusammenhang mit FIG 1 bereits dargelegt, aus einem ersten npn- und einem zweiten pnp-Transistor zusammensetzt. Der Thyristor besteht aus p-Substrat 9, der zweiten, einschließlich ersten, n-leitenden Zone 11, 13′, der dritten Zone 7, 7′ und der vierten, n-leitenden Zone 6. Der integrierte Widerstand R wird durch die Dimensionierung der vierten Zone 6 innerhalb der dritten Zone 7, 7′ einerseits und durch Überlappung des Anschlusses 1 über die dritte Zone 7, 7′ sowie durch die Aussparung 10 in der vierten Zone 6 andererseits gebildet. Das zusätzliche p-Gebiet 5, 5′ bildet zusammen mit der n-leitenden Zone 13′ bzw. der Buried Layer 11 eine Diode 5 (FIG 3) bzw. mit dem p-Substrat 9 (bzw. dem Isolationsrahmen 12, 14) einen Substrat-pnp-Transistor 5′ (FIG 4).

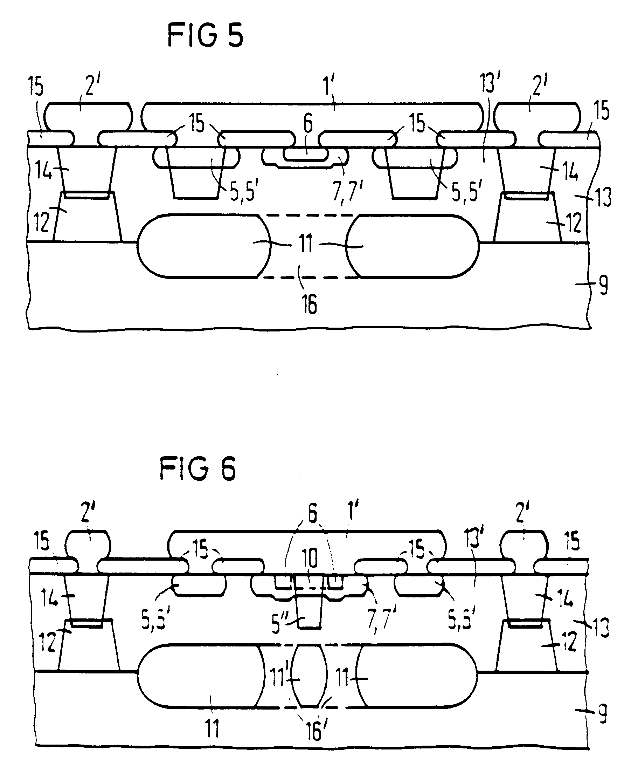

In FIG 5 ist eine weitere Ausführungsform der erfindungsgemäßen Eingangsschutzstruktur in einem Halbleitersystem dargestellt. Einander entsprechende Teile sind mit den gleichen Bezugszeichen wie in den anderen Figuren versehen. Auch die in den Figuren 3 und 4 gezeigten Ersatzschaltbilder gelten für dieses Ausführungsbeispiel. Lediglich der integrierte Widerstand R ist für dieses Beispiel unendlich groß, weil dritte Zone 7, 7′ und vierte Zone 6 nicht mehr die spezielle Anordnung gemäß FIG 2 aufweisen und deren Emittergebiet (vierte Zone 6) und Basisgebiet (dritte Zone 7, 7′) nicht mehr miteinander verbunden sind.

Im folgenden werden die Unterschiede zu der in FIG 2 dargestellten Ausführungsform erläutert. In diesem Ausführungsbeispiel ist der Abstand zwischen den zusätzlichen Zonen 5, 5′ des ersten Leitungstyps, in diesem Beispiel der p-Gebiete und dem Isolationsrahmen 12, 14 der pnp-Basisweite angepaßt. Auf der Oberfläche des Halbleitersystems ist wiederum eine isolierende Schicht 15 aufgebracht, die zur Herstellung der Anschlußöffnungen entsprechend strukturiert ist. In diesem Beispiel überdeckt die isolierende Schicht 15 auch die dritte Zone 7, 7′ und läßt nur die Oberfläche der vierten Zone zum Kontaktieren frei. Über einen ersten Anschluß 1′ sind daher nur die vierte Zone 6 und die zusätzlichen Zonen 5, 5′ an den Eingang 1 angeschlossen. Über den zweiten Anschluß 2′ ist wiederum das Halbleitersubstrat 9 über den Isolationsrahmen 12, 14 mit dem Bezugspotential 2 verbunden.

Die Struktur der FIG 2 beinhaltet sowohl negative als auch positive Sperrspannungen, so daß diese zum Schutz von Eingängen mit zu verarbeitenden Signalspannungen beider Polaritäten eingesetzt werden kann.

Sind keine negativen Signalspannungen vorhanden, kann eine Schutzstruktur gemäß FIG 5 verwendet werden. Der Durchbruch liegt bei negativer Spannung im Bereich von -0,7V, wohingegen eine positive Sperrspannung in der Größenordnung von U (CEO) des lateralen pnp-Transistors erwartet wird. Der Vorteil dieser Struktur besteht vor allem in der problemloseren technologischen Realisierung gegenüber der Struktur gemäß FIG 2, wo die Einstellung des integrierten Widerstandes von den Fertigungstoleranzen der jeweiligen Prozeßlinie abhängt.

Die ESD-Schutzwirkung beider Strukturen kann erhöht werden, indem man die Buried-Layer 11 mit dem Isolationsrahmen 12, 14 zusammenlaufen läßt. Hierbei wird allerdings die Durchbruchspannung für positive Signalspannungen erniedrigt und die zusätzliche Kapazität erhöht. Wird dagegen der Abstand zwischen Buried-Layer 11 und unterem Isolationsrahmen 12 beibehalten und lediglich der obere Isolationsrahmen 14 über der Buried-Layer 11 bei gleichbleibenden Abständen bezüglich der aktiven Zone, d.h. den Emitter- und Basis-Gebieten, angeordnet, kann eine Verminderung der Durchbruchspannungen bei verbesserter Schutzwirkung verhindert werden.

Das in FIG 6 dargestellte Ausführungsbeispiel zeigt, daß die Ableitwirkung des im Thyristor integrierten Substrat-pnp-Transistors 4 (FIG 1) durch das Einbringen einer p-Isolations-Diffusion 5˝ in die Aussparung 10 der vierten Zone 6 des n-Leitfähigkeitstyps noch erhöht werden kann. Handelt es sich hierbei um eine relativ hochohmige Isolationsdiffusion (einige hundert Ohm/Quadrat), kann auch die vollständige dritte Zone 7, 7′ des P-Leitfähigkeitstyps durch diese ersetzt werden, ohne die effektive Basisweite des npn-Transistors 3 wesentlich zu erhöhen. Bei Prozeß linien mit einer Einfach-Isolation muß allerdings unterhalb der p-Isolations-Diffusions-Zone 5˝ ein Buried-Layer-Gebiet 11′ angeordnet sein, um einen Kurzschluß zum Substrat 9 zu vermeiden. Die Aussparung des Buried-Layer-Gebietes entartet damit zu einem Ring 16′ bzw. zu einem streifenförmigen Aufbau, welcher unterhalb der vierten Zone 6 angeordnet ist. Bei Prozeßlinien mit einer Doppel-Isolation kann das zusätzliche Buried-Layer-Gebiet 11′ vermieden werden. Durch die Anordnung des Isolations-Diffusions-Gebiets 5˝ in der Aussparung der vierten Zone 6 wird zum einen eine höhere Emitter-Effektivität des Substrat-pnp-Transistprs 4 erreicht, ohne daß die Basisweite des npn-Transistors 3 in ungünstiger weise vergrößert wird. Zum anderen erfolgt durch die tiefreichende Diffusion die Ableitung der Impulse effektiv von der Oberfläche in die Tiefe. Diese Anordnung unterstützt die Substrat-pnp-Wirkung der zusätzlichen p-Gebiete 5, 5′. Ferner wird hiermit sogar eine Erhöhung der Schutzwirkung einer Eingangsschutzstruktur gemäß der europäischen Patentanmeldung EP-A-0 414 934 ohne die Verwendung der zusätzlichen p-Gebiete 5, 5′ erreicht.

## Patentansprüche

1. Eingangsschutzstruktur in integrierten Schaltungen, die in einem Halbleitersubstrat zwischen einen Eingang (1) und ein Bezugspotential (2) geschaltet ist und mindestens einen Thyristor enthält, der eine Vierschicht-Struktur aufweist, welche gebildet ist aus dem einen ersten Leitungstyp aufweisenden Halbleitersubstrat (9), aus einem aus einer ersten und einer zweiten Zone bestehenden Gebiet (11, 13′) eines zweiten Leitungstyps, wobei die zweite Zone (13′) von einer auf dem Halbleitersubstrat (9) angeordneten epitaktischen Schicht (13) gebildet ist und die erste Zone (11) eine in das Halbleitersubstrat eindiffundierte und an die zweite Zone (13′) grenzende vergrabene Schicht darstellt, aus einer dritten Zone (7, 7′) des ersten Leitungstyps, die oberhalb der ersten Zone (11) in die zweite Zone (13′) eindiffundiert ist, und aus einer vierten Zone (6) des zweiten Leitungstyps, die in der dritten Zone (7, 7′) eindiffundiert ist, so daß sie von der zweiten Zone (13′) durch die dritte Zone (7, 7′) isoliert ist, **dadurch gekennzeichnet**, daß die zweite Zone (13′) des zweiten Leitungstyps durch einen Isolationsrahmen (12, 14) bildende Diffusionszonen des ersten Leitungstyps, die durch die epitaktische Schicht (13) hindurch bis zum Halbleitersubstrat (9) reichen, seitlich begrenzt ist; daß in die zweite Zone (13′) des zweiten Leitungstyps von dieser beanstandet jeweils eine zusätzliche Zone (5, 5′) des ersten Leitungstyps eingebracht ist, die zusammen mit der vierten Zone (6) des zweiten Leitungstyps über einen gemeinsamen ersten Anschluß (1′) mit dem Eingang (1) verbunden ist; und daß das Halbleitersubstrat (9) über den Isolationsrahmen (12, 14) und einen zweiten Anschluß (2′) an das Bezugspotential (2) angeschlossen ist.

2. Eingangsschutzstruktur nach Anspruch 1, **dadurch** **gekennzeichnet**, daß auch die dritte Zone (7, 7′) des ersten Leitungstyps mit der vierten Zone (6) des zweiten Leitungstyps und den zusätzlichen Zonen (5, 5′) des ersten Leitungstyps über den gemeinsamen ersten Anschluß (1′) mit dem Eingang (1) verbunden ist.

3. Eingangsschutzstruktur nach Anspruch 1 oder 2, **dadurch** **gekennzeichnet**, daß die zusätzlichen Zonen (5, 5′) des ersten Leitungstyps p-Basis-Diffusionsgebiete oder p-Isolations-Diffusionsgebiete sind.

4. Eingangsschutzstruktur nach einem der Ansprüche 1 bis 3, **gekennzeichnet durch** einen streifenförmigen oder zentralsymmetrischen Aufbau.

## Claims

1. Input protection structure in integrated circuits which is connected in a semiconductor substrate between an input (1) and a reference potential (2) and contains at least one thyristor having a four-layer structure formed from the semiconductor substrate (9) having a first conduction type, from a region (11, 13′) of a second conduction type comprising a first and a second zone, the second zone (13′) being formed by an epitaxial layer (13) disposed on the semiconductor substrate (9) and the first zone (11) being a buried layer diffused into the semiconductor substrate and adjoining the second zone (13′), from a third zone (7, 7′) of the first conduction type which is diffused into the second zone (13′) above the first zone (11), and from a fourth zone (6) of the second conduction type which is diffused into the third zone (7, 7′) so that it is isolated from the second zone (13′) by the third zone (7, 7′), characterized in that the second zone (13′) of the second conduction type is laterally bounded by diffusion zones of the first conduction type which form an isolating frame (12, 14) and which extend through the epitaxial layer (13) down to the semiconductor substrate (9); in that an additional zone (5, 5′) of the first conduction type which is connected, together with the fourth zone (6) of the second conduction type via a common first terminal (1′) to the output (1) is introduced into the second zone (13′) of the second conduction type on both sides of the third zone (7, 7′) in each case and spaced apart from the latter; and in that the semiconductor substrate (9) is connected to the reference potential (2) via the isolating frame (12, 14) and a second terminal (2′).

2. Input protection structure according to Claim 1, characterized in that the third zone (7, 7′) of the first conduction type is also connected by means of the fourth zone (6) of the second conduction type and the additional zones (5, 5′) of the first conduction type to the input (1) via the common first terminal (1′).

3. Input protection structure according to Claim 1 or 2, characterized in that the additional zones (5, 5′) of the first conduction type are p-type base diffusion regions or p-type isolating diffusion regions.

4. Input protection structure according to one of Claims 1 to 3, characterized by a strip-type or centrally symmetrical structure.

## Revendications

1. Structure de protection d'entrée dans des circuits intégrés, qui est branchée entre une entrée (1) et un potentiel de référence (2) dans un substrat semiconducteur et contient au moins un thyristor, qui possède une structure à quatre couches, qui est formée par le substrat semiconducteur (9) possédant un premier type de conductivité, par une région (11,13′) possédant un second type de conductivité et constituée par des première et seconde zones, la seconde zone (13′) étant formée par une couche épitaxiale (13) disposée sur le substrat semiconducteur (9) et la première zone (11) représentant une couche enterrée qui est introduite par diffusion dans le substrat semiconducteur et qui jouxte la seconde zone (13′), par une troisième zone (7,7′), qui a le premier type de conductivité et qui est introduite par diffusion dans la seconde zone (13′) au-dessus de la première zone (11), et par une quatrième zone (6), qui a le second type de conductivité et qui est introduite par diffusion dans la troisième zone (7,7′) de sorte qu'elle est isolée de la seconde zone (13′) par la troisième zone (7,7′), caractérisée par le fait que la seconde zone (13′) possédant le second type de conductivité est limitée latéralement par des zones de diffusion, qui ont le premier type de conductivité, qui forment un cadre isolant (12,14) et qui s'étendent à travers la couche épitaxiale (13) jusqu'au substrat semiconducteur (9); dans la seconde zone (13′) possédant le second type de conductivité et à une distance de cette dernière est insérée respectivement une zone supplémentaire (5,5′) possédant le premier type de conductivité et qui est reliée, conjointement avec la quatrième zone (6) possédant le second type de conductivité, à l'entrée (1) par l'intermédiaire d'une première borne commune (1′); et le substrat semiconducteur (9) est raccordé au potentiel de référence (2) par l'intermédiaire du cadre isolant (12,14) et d'une seconde borne (2′).

2. Structure de protection d'entrée suivant la revendication 1, caractérisée par le fait que la troisième zone (7,7′) possédant le premier type de conductivité ainsi que la quatrième zone (6) possédant le second type de conductivité et les zones supplémentaires (5,5′) possédant le premier type de conductivité sont reliées à l'entrée (1) par l'intermédiaire de la première borne commune (1′).

3. Structure de protection d'entrée suivant la revendication 1 ou 2, caractérisé par le fait que les zones supplémentaires (5,5′) possédant le premier type de conductivité sont des régions diffusées de base de type p ou des régions diffusées d'isolation de type p.

4. Structure de protection d'entrée suivant l'une des revendications 1 à 3, caractérisé par une structure en forme de bande ou à symétrie centrale.
